# EUROPEAN PATENT APPLICATION

(11) **EP 3 741 521 A1**
(43) Date of publication of application: **25.11.2020**
(21) Application number: 18901328.7
(22) Date of filing: 19.12.2018
(51) Int. Cl.: B25J 13/00, B23P 19/04

(54) **ROBOT DEVICE, AND METHOD FOR MANUFACTURING ELECTRONIC APPARATUS**

(30) Priority: 19.01.2018 JP 2018007114
(71) Applicant: Sony Corporation, 108-0075 Tokyo (JP)
(72) Inventor: KOBORI, Yuji, Tokyo 108-0075 (JP); TONEGAWA, Makoto, Tokyo 108-0075 (JP)
(74) Representative: D Young & Co LLP
(86) International application number: PCT/JP2018/046796
(87) International publication number: WO 2019/142583

(57) **Abstract**

A robot apparatus according to an embodiment of the present technology includes a first robot and a second robot. The first robot includes a first hand section and a first control section. The first hand section is configured to be capable of holding one part of a work. The first control section is configured to be capable of controlling the first hand section and generating a reference signal including information about an action of the first hand section. The second robot includes a second hand section and a second control section. The second hand section is configured to be capable of holding another part of the work. The second control section is configured to be capable of selectively executing a first control mode that controls the second hand section and a second control mode that controls the second hand section by cooperating with the first hand section on the basis of the reference signal.

## Description

### Technical Field

The present technology relates to a robot apparatus used for manufacturing an electronic apparatus having a flexible member such as a harness, an FFC (Flexible Flat Cable) and an FPC (Flexible Printed Circuit) including, for example, a plurality of wires and a terminal section connected to their ends, and a method of manufacturing the electronic apparatus.

### Background Art

For example, in manufacturing of the electronic apparatus, an industrial robot is widely used for assembling the electronic apparatus. For example, a technique of automatically performing a step of connecting a linear member such as a cable and a connector part (for example, see Patent Literature 1).

### Citation List

### Patent Literature

Patent Literature 1: Japanese Patent Application Laid-open No. 2014-176917

### Disclosure of Invention

### Technical Problem

In a case where one robot performs an operation of assembling a device section having a wiring cable to a connector in a housing, it needs to sequentially execute steps of temporarily storing the device section near the housing, connecting the wiring cable to the connector, and assembling the device section into the housing. However, such an operation is not only ineffective, but also needs to ensure a temporal storage space of the device section to thereby undesirably reducing an operation space. In addition, in a case where the wiring cable is short, it may be difficult to even ensure a space for temporarily storing the device section.

On the other hand, in a case where a plurality of robots is used to execute a similar operation, it needs to strictly control each robot. For example, there is a problem that it is difficult to appropriately reflect a defect of the operation by one robot on an operation by other robot.

The present technology is made in view of the above-mentioned circumstances, and it is an object of the present technology to provide a robot apparatus that can appropriately perform an operation involving a plurality of robots to improve productivity and a method of manufacturing an electronic apparatus. Solution to Problem

A robot apparatus according to an embodiment of the present technology includes a first robot and a second robot.

The first robot includes a first hand section and a first control section. The first hand section is configured to be capable of holding one part of a work. The first control section is configured to be capable of controlling the first hand section and generating a reference signal including information about an action of the first hand section.

The second robot includes a second hand section and a second control section. The second hand section is configured to be capable of holding another part of the work. The second control section is configured to be capable of selectively executing a first control mode that controls the second hand section and a second control mode that controls the second hand section by cooperating with the first hand section on the basis of the reference signal.

In the robot apparatus, the second control section is configured to be capable of executing the second control mode that controls the first and second hand section in a coordinated manner on the basis of the information about the action of the first hand section. Thus, an operation involving a plurality of robots can be appropriately performed.

The second control section may be configured to generate a control signal that controls the first hand section in the second control mode, and the first control section may be configured to control the first hand section on the basis of the control signal.

The second control section may be configured to detect the position of the first hand section on the basis of the reference signal in the second control mode and individually control the first hand section and the second hand section by using a common coordinate system to which the respective first hand section and second hand section belong.

When the second control section detects that the first hand section arrives at a first predetermined position in the second control mode, the second control section may be configured to allow the holding of the work by the first hand section to be released and generate a withdrawn command that allows the first hand section to be moved to a second predetermined position different from the first predetermined position as the control signal.

The second control section may allow the second hand section and the first hand section to be synchronized and activated in the second control mode.

Alternatively, the second control section may allow the second hand section and the first hand section to be moved in the same direction in the second control mode.

Alternatively, the second control section may allow the second hand section and the first hand section to be moved at the same speed in the second control mode.

The robot apparatus may further includes a controller that transmits a coordination control command signal allowing to execute the second control mode to the second control section.

A method of manufacturing an electronic apparatus according to an embodiment of the present technology including a first work having a connection section and a second work having a linear or bandlike flexible member assembled to the first work and connected to the connection section includes holding the flexible member of the second work held by the second robot with the first robot.

It allows the second work and the flexible member to be moved toward the first work at the same time while the first robot and the second robot are coordinated and controlled.

After the flexible member is connected to the connection section, the second work is assembled to the first work.

### Advantageous Effects of Invention

As described above, according to the present technology, an operation involving a plurality of robots can be appropriately performed to improve productivity.

It should be noted that the effects described here are not necessarily limitative and may be any of effects described in the present disclosure.

### Brief Description of Drawings

[Fig. 1] Fig. 1 is a schematic side view showing a manufacturing apparatus (robot apparatus) of an electronic apparatus according to an embodiment of the present technology.
[Fig. 2] Fig. 2 is a schematic sectional side view showing a structure of a work.
[Fig. 3] Fig. 3 is a block diagram showing a configurations of the robot apparatus.
[Fig. 4] Fig. 4 is a schematic process chart of describing a method of manufacturing the work.
[Fig. 5] Fig. 5 is a schematic process chart of describing a method of manufacturing the work.
[Fig. 6] Fig. 6 is a sequence diagram of describing an action of the robot apparatus.
[Fig. 7] Fig. 7 is a flowchart showing a processing process of one robot of the robot apparatus.

### Mode(s) for Carrying Out the Invention

Hereinafter, an embodiment of the present disclosure will be described with reference to the drawings.

Hereinafter, embodiments of the present technology will be described with reference to the drawings.

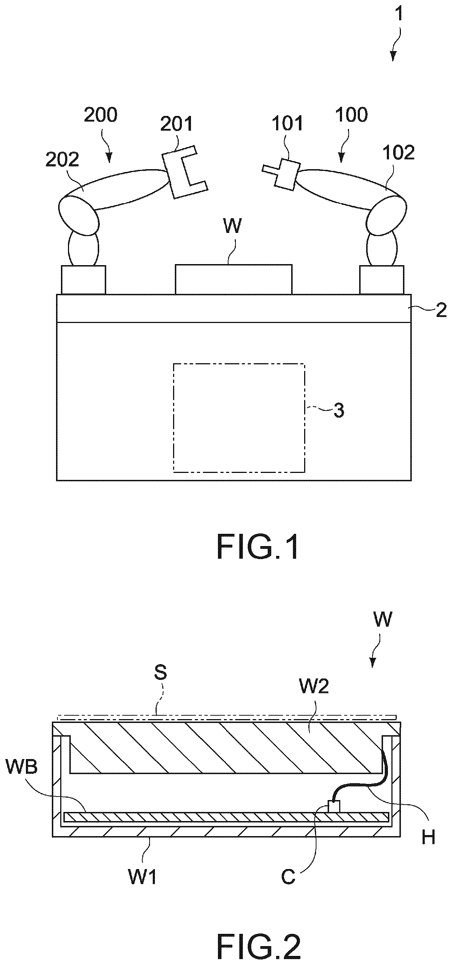

Fig. 1 is a schematic side view showing a manufacturing apparatus (robot apparatus) of an electronic apparatus according to an embodiment of the present technology. In this embodiment, an example that the present technology is applied to an assembly process of the electronic apparatus.

### [Schematic structure of robot apparatus]

A robot apparatus 1 in this embodiment includes an assembly robot 100 (first robot), a transfer robot 200 (second robot), a workbench 2 that supports a semifinished product (hereinafter also referred to as work W) of the electronic apparatus, and a controller 3 that controls a whole system including the assembly robot 100 and the transfer robot 200.

The assembly robot 100 includes a hand section 101 (first hand section), an articulated arm 102 capable of allowing the hand section 101 to be moved at any coordinate position with 6-axis freedom, a control section (first control section) that controls driving thereof, and the like.

The transfer robot 200 includes a hand section 201 (second hand section), an articulated arm 202 capable of allowing the hand section 201 to be moved at any coordinate position with 6-axis freedom, a control section (second control section) that controls driving thereof, and the like.

Each of the articulated arms 102 and 202 is connected to the workbench 2 or a driving source (not shown) arranged closer to the workbench 2.

Fig. 2 is a schematic sectional side view showing a structure of the work W.

The work W includes a base section W1, a wiring board WB arranged within the base section W1, a connector C (connection section) mounted on a surface of the wiring board W2, a device section W2 assembled to a base section W1 so as to face to the wiring board WB, and a wiring member H extended from the device section W2 and connected to the connector C. The work W is composed of an assembly including a first work including the base section W1 and the wiring board WB (connector C) and a second work including the device section W2 and the wiring member H.

The base section W1 constitutes, for example, a bottom housing or a top housing of the electronic apparatus and has a planar shape of a rough rectangle shape. Inside of the base section W1, other boards and device sections may be incorporated in advance other than the wiring board WB and the device section W2.

The device section W2 corresponds to an electric and electronic apparatus unit such as a power source unit, an optical disc device, and an HDD (Hard Disk Drive). The device section W2 is engageable with an upper end of the base section W1 and has a planar shape of a rough rectangle shape.

The wiring member H is composed of a harness having a terminal section (Hc) at a tip for the connector C but may be composed of other linear or bandlike flexible members such as a cable, an FFC and an FPC.

The robot apparatus 1 assembles the work W on the workbench 2. As details will be described later, after the base section W1 is mounted on the workbench 2 by the transfer robot 200, an operation of assembling the device section W2 to the base section W1 is executed while the device section W2 is held by the transfer robot 200 and the wiring member H is held by the assembly robot 100, respectively.

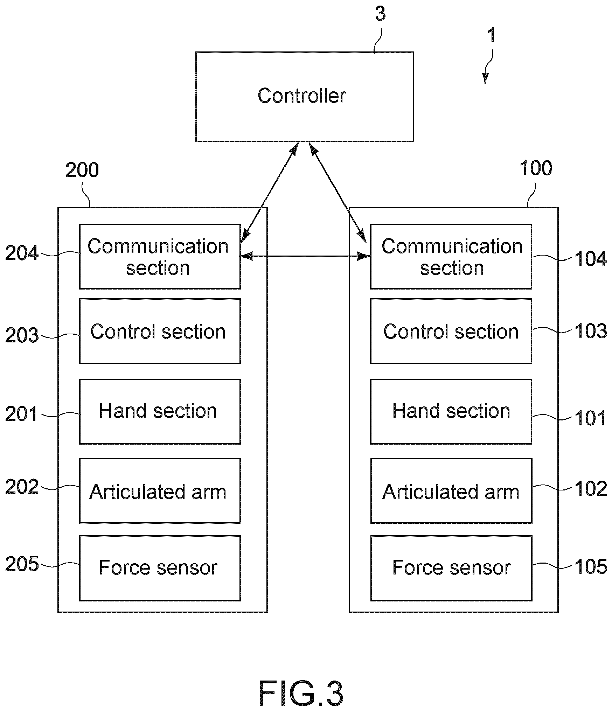

Fig. 3 is a block diagram showing a configurations of the assembly robot 100 and the transfer robot 200. The assembly robot 100 and the transfer robot 200 are configured similarly and include the hand sections 101 and 201, the articulated arms 102 and 202 as well as control sections 103 and 203, communication sections 104 and 204, force sensors 105 and 205 and the like. The assembly robot 100 and the transfer robot 200 may further include cameras, illumination light, and the like (not shown).

The hand sections 101 and 201 are typically composed of clamp units. Specifically, the hand section 101 of the assembly robot 100 is composed of a finger unit capable of clamping the wiring member H in two directions. On the other hand, the hand section 201 of the transfer robot 200 is configured to be capable of clamping four sides of the base section W1 or the device section W2 at the same time. The hand section 201 may be composed of a suction unit capable of holding the base section W1 or the device section W2 by vacuum suction in place of the clamp unit.

Furthermore, the hand sections 101 and 201 may be replaceable with different attachments depending on types of operations.

The articulated arms 102 and 202 allow the hand sections 101 and 102 to be moved or change their postures. The articulated arms 102 and 202 are typically composed of vertical articulated arms, horizontal articulated arms, or the like, and may be composed of XYZ orthogonal robots (3-axis robots) or the like.

The control sections 103 and 203 are composed of a computer including a CPU (Central Processing Unit), a memory, or the like. The control sections 103 and 203 are configured to be capable of selectively executing a first control mode that an action of each of the assembly robot 100 and the transfer robot 200 is independently controlled and a second control mode that the assembly robot 100 and transfer robot 200 are controlled each other in a coordinated manner.

In the robot apparatus 1 of this embodiment, own operations are assigned respectively to the assembly robot 100 and the transfer robot 200 with respect to assembling of the work W. Only with respect to the assembly process of the device section W2 to the base section W1, the respective robots 100 and 200 are configured to be capable of acting in the coordinated manner. When the respective robots perform the own operations, the first control mode is selected. When the respective robots 100 and 200 perform the operations in the coordinated manner, the second control mode is selected.

As the own operations executed in the first control mode, for example, with respect to the transfer robot 200, it includes positioning and transfer of the base section W1 and the device section W2, transfer of the assembled work W, and the like, and with respect to the assembly robot 100, it includes mounting of a shield plate S to the device section W2 assembled to the base section W1 (see Fig. 1), attaching a fixing screw, and the like.

The coordination operations executed in the second control mode include action controls such that, for example, the two hand sections 101 and 201 are allowed to be synchronized and activated, moved in the same direction, moved at the same speed, etc. At this time, if one hand section is stopped by causing a trouble in the action (e.g., malfunction of hand section, collision with other member, etc.), the other hand section is also stopped. In such a configuration, it can prevent a trouble caused by activating only one hand section (e.g., disconnection or damage of wiring member H) before it happens.

During execution of the second control mode, a control section 203 of the transfer robot 200 is in a higher level than a control section 103 of the assembly robot 100 and is configured to be capable of generating a control signal not only for controlling an action of the hand section 201 but also for controlling an action of the hand section 101 of the assembly robot 100. At this time, the control section 103 of the assembly robot 100 controls the action of the hand section 101 in accordance with the control signal from the transfer robot 200.

Note that the control of the hand sections 101 and 201 or the control of the actions thereof include the control of the actions of the articulated arms 102 and 202 allowing the hand sections 101 and 201 to be moved at any coordinate positions with 6-axis freedom.

The control section 103 of the assembly robot 100 generates a reference signal including information about the position, the posture, an action status, and the like, and transmits the reference signal to the transfer robot 200 in the second control mode. The control section 103 receives the control signal transmitted from the control section 203 of the transfer robot 200, and controls the action of the hand section 101 on the basis of the control signal in the second control mode.

On the other hand, the control section 203 of the transfer robot 200 receives the reference signal from the assembly robot 100, and controls the action of the hand section 101 of the assembly robot 100 so as to cooperate with the action of the hand section 201 on the basis thereof in the second control mode.

The communication sections 104 and 204 are configured to be capable of receiving and transmitting the reference signal and the control signal. In other words, the communication section 104 of the assembly robot 100 is configured to be capable of receiving and transmitting the reference signal and the control signal. On the other hand, a communication section 204 of the transfer robot 200 is configured to be capable of receiving the reference signal and transmitting the control signal.

A communication method in the communication sections 104 and 204 may be wired or wireless.

Furthermore, the communication sections 104 and 204 are configured to be capable of transmitting and receiving to/from the controller 3. The controller 3 is configured to be capable of monitoring the actions of the assembly robot 100 and the transfer robot 200 on the basis of control information transmitted from the communication sections 104 and 204, making the action of the robot apparatus 1 to stop when an abnormal action is detected, and issuing a predetermined alert.

In this embodiment, the controller 3 is configured to be capable of determining a start and an end (release) of a coordination control by the assembly robot 100 and the transfer robot 200 on the basis of the control information, and notifying of the respective robots 100 and 200.

The force sensors 105 and 205 are configured to be capable of attaching to the respective hand sections 101 and 201, and detecting an external stress that acts on the hand sections 101 and 201. The force sensors 105 and 205 are composed of a variety of sensors capable of detecting an external force such as a strain sensor and an electrostatic sensor, and outputs therefrom are transmitted to the respective control sections 103 and 203.

The force sensor 105 of the assembly robot 100 detects a stress acting on the hand section 101 typically when the wiring member H is handled, the wiring member H is connected to the connector C, etc.

On the other hand, the force sensor 205 of the transfer robot 200 detects a stress acting on the hand section 201 when the base section W1, the device section W2, and work W are transferred, when the device section W2 is assembled to the base section W1, and so on.

### [Method of manufacturing electronic apparatus]

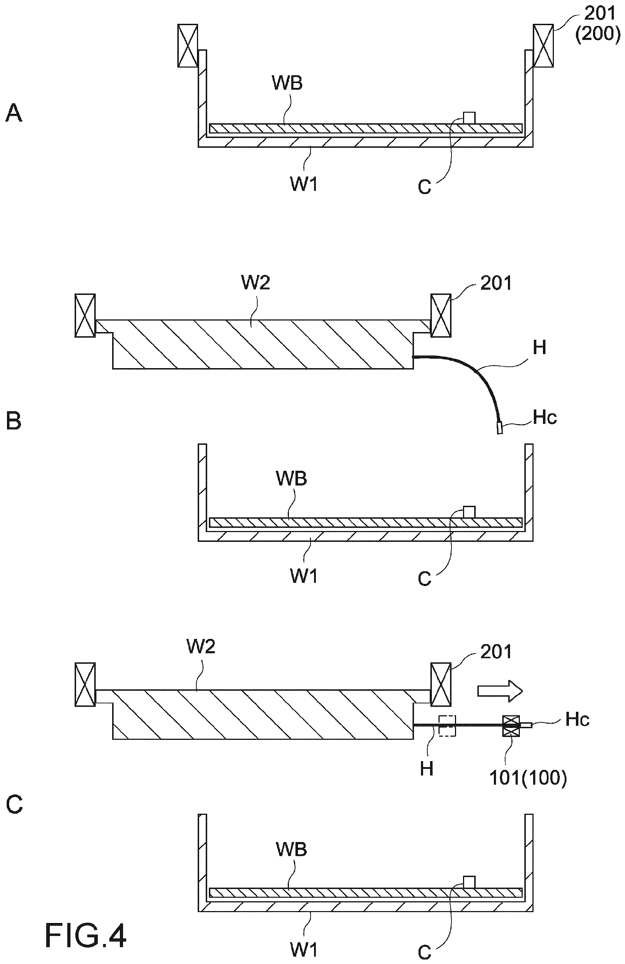

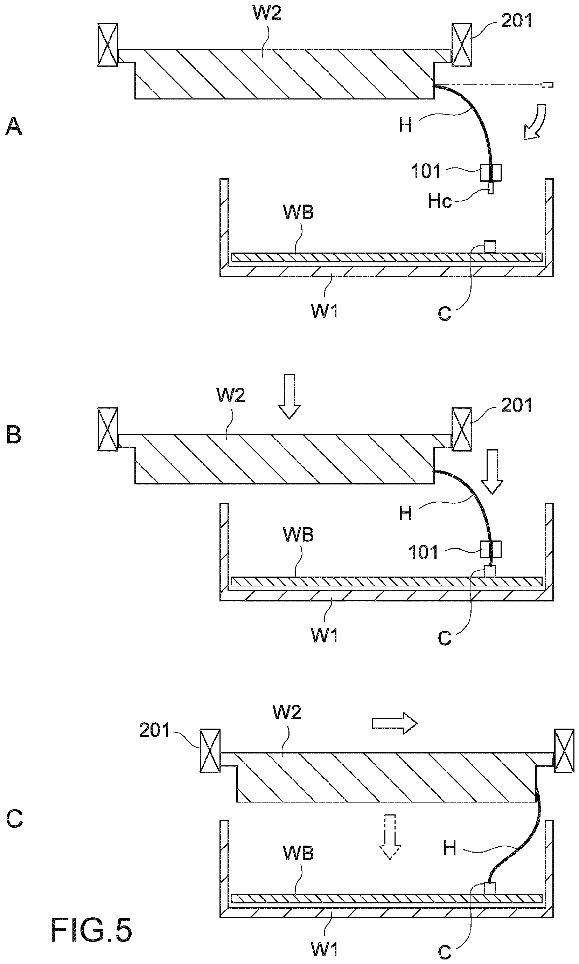

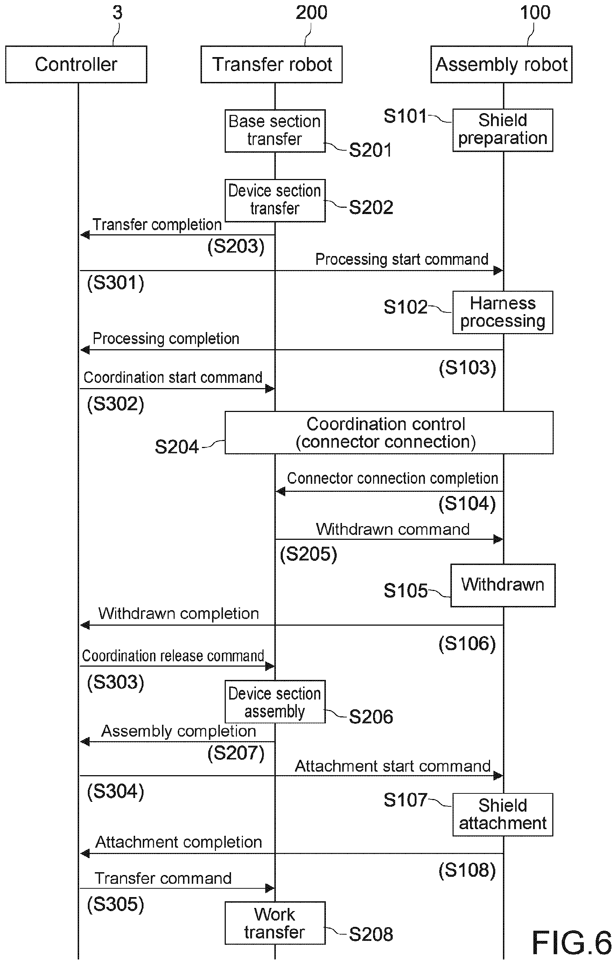

Next, details of the respective control sections 103 and 203 will be described together with the action of the robot apparatus 1. Fig. 4 and Fig. 5 are schematic process charts of describing a method of manufacturing the work W. Fig. 6 is a sequence diagram of describing an action of the robot apparatus 1.

In Fig. 6, 100 series Steps denote processing executed by the assembly robot 100, 200 series Steps denote processing executed by the transfer robot 200, and 300 series Steps denote processing executed by the controller 3.

Hereinafter, the assembly robot 100 or the transfer robot 200 will be mainly described, and independent controls by the control sections 103 and 203 (first control mode) are executed, unless otherwise specified. In addition, a variety of notifications transmitted from the assembly robot 100 to the transfer robot 200 or the controller 3 are generated in the control section 103 and transmitted via the communication section 104. Similarly, a variety of notifications transmitted from the transfer robot 200 to the assembly robot 100 or the controller 3 are generated at the control section 203 and transmitted via the communication section 204.

First, the base section W1 is mounted on the workbench 2 (Fig. 1) at a predetermined position by the hand section 201 of the transfer robot 200 (Fig. 4A, Step 201). Subsequently, the device section W2 is transferred to a predetermined position directly above the base section W1 by the hand section 201 of the transfer robot 200 (Fig. 4B, Step S202).

The predetermined position is set to an appropriate position directly above the connector C in the base section W1 capable of ensuring a working space of the hand section 101 of the assembly robot 100.

After the device section W2 is transferred, the transfer robot 200 transmits a transfer completion notification to the controller 3 (Step S203), and keeps a stationary status of the hand section 201 while holding the device section W2 at its transfer position. When the controller 3 receives the transfer completion notification from the transfer robot 200, the controller 3 transmits a start notification of harness processing to the assembly robot 100 (Step S301).

While the base section W1 and the device section W2 are transferred by the transfer robot 200, the assembly robot 100 takes out the shield plate S from a stocker and mounts it on a predetermined temporal storage space (Step 101). Then, when the start notification of the harness processing is received from the controller 3, the hand section 101 is allowed to be moved to the device section W2 transferred to the position shown in Fig. 4B to start the harness processing to which a terminal section Hc of the wiring member H is changed to a predetermined posture (Step 102) .

Fig. 4C and Fig. 5A show processes of the harness processing by the assembly robot 100.

The assembly robot 100 holds the wiring member H that projects outwardly from one side of the device section W2 with a predetermined grip force by using the hand section 101 and then makes the hand section 101 to be moved in the direction away from the device section W2 and to stop at the position with which the terminal section Hc of the tip of the wiring member H is in contact (Fig. 4C).

The predetermined grip force is set to have an appropriate magnitude such that the hand section 101 is capable of being slid with respect to the wiring member H while the wiring member H is held. The grip force of the hand section 101 and contact detection between the hand section 101 and the terminal section Hc are adjusted on the basis of an output of the force sensor 105. A sliding direction of the hand section 101 with respect to the wiring member H is not especially limited, may be the horizonal direction as shown in Fig. 4C, or may be diagonally upward or diagonally downward with respect to the horizontal.

Subsequently, the assembly robot 100 makes the hand section 101 to be moved at a position to which the terminal section Hc of the wiring member H faces to the connector C in the base section W1 in the up and down directions (Fig. 5A). At this time, the terminal section Hc is changed to have a posture being capable of connecting to the connector C from above. After a posture change of the terminal section Hc is completed, the assembly robot 100 transmits a processing completion notification to the controller 3 (Step 103).

When the controller 3 receives the processing completion notification from the assembly robot 100, the controller 3 transmits a start command of the coordination control to the transfer robot 200 (Step 302). When the transfer robot 200 receives the start command of the coordination control from the controller 3, the transfer robot 200 starts a connection operation between the terminal section Hc and the connector C by a coordination action with the assembly robot 100 (Step 204) .

### (Coordination control)

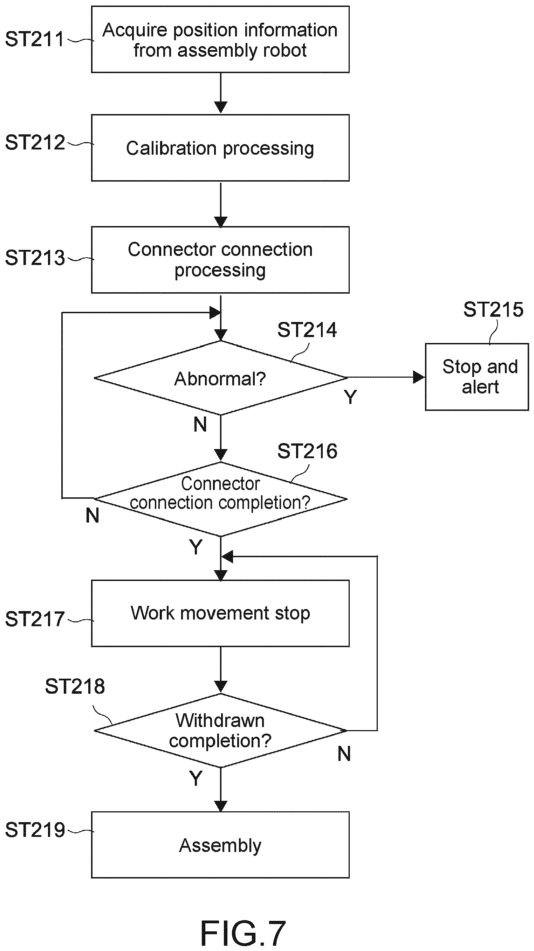

The transfer robot 200 switches from the first control mode to the second control mode and allows the hand section 201 and the hand section 101 of the assembly robot 100 to be coordinated and activated. Fig. 7 is a flowchart showing a processing process of the control section 203 of the transfer robot 200.

The control section 203 acquires information (reference signal) about the position of the hand section 101 that holds the wiring member H from the assembly robot 100 (Step 211). As described above, the reference signal is directly transmitted and received via the communication sections 104 and 204.

Subsequently, the control section 203 detects the position of the hand section 101 of the assembly robot 100 on the basis of the reference signal and executes calibration processing of setting a common coordinate system to which the respective two hand sections 101 and 201 belong (Step S212). Thus, in the control section 203, it becomes possible to monitor the position of the hand section 101 of the assembly robot 100 and it becomes possible to easily determine and adjust a relative position of the respective hand sections 101 and 201.

The control section 203 individually controls the respective hand sections 101 and 201 by using the common coordinate system and executes connection processing between the terminal section Hc of the wiring member H and the connector C (Step S213). Specifically, as shown in Fig. 5B, while movements of the hand sections 101 and 201 are coordinated each other so as to keep the relative position between the device section W2 and the terminal section Hc within a predetermined range, the device section W2 and the terminal section Hc are lowered toward the base section W1.

At this time, the control section 203 generates the control signal that controls the action of the hand section 101, directly transmits the control signal to the assembly robot 100 via the communication sections 104 and 204 (not via controller 3), and makes the control section 103 of the assembly robot 100 to control the hand section 101. Thus, as rapid communication can be established without being influenced by a communication delay between the assembly robot 100 and the transfer robot 200 via the controller 3, it becomes possible to accelerate the work.

The control section 203 generates a control signal that allows the hand section 101 to be synchronized and moved with the hand section 201 as the control signal. Thus, since the hand section 201 can be synchronized and moved with the hand section 101 of the assembly robot 100, a change in a relationship of the relative position between the device section W2 and the terminal section Hc is suppressed within a predetermined range. The hand sections 101 and 201 are not always moved or stopped at the same time, and the actions of the hand sections 101 and 201 may be synchronized only for at least a part of the time of the connection processing.

The control section 203 generates a signal that allows the hand section 101 to be moved in the same direction (in this embodiment, vertically downward) of the hand section 201 as the control signal. Thus, since the hand section 201 can be moved in the same direction of the hand section 101 of the assembly robot 100, a change in the distance between the device section W2 and the terminal section Hc in the horizontal direction can be avoided.

The control section 203 generates a control signal that allows the hand section 101 to be moved at the same speed of the hand section 201 as the control signal. Thus, since the hand section 201 can be moved at the same speed of the hand section 101 of the assembly robot 100, a change in the distance between the device section W2 and the terminal section Hc in the vertical direction is avoided.

The control section 203 determines whether or not an abnormality of the hand sections 101 and 201 is present during the connection processing (Step 214). For example, in a case where one hand section 101 comes in contact with a side wall, or the like of the base section W1 and stops moving, the other hand section is allowed to stop moving and a predetermined alert is allowed to be issued (Step 215).

The control section 203 continues a control of the coordination action of the hand sections 101 and 201 until the connection operation of the terminal section Hc to the connector C is completed (Step 216). After the connection operation is completed, the assembly robot 100 transmits a connector connection completion notification to the transfer robot 200 (Step 104 in Fig. 6). When the control section 203 receives the connector connection completion notification, the control section 203 stops a lowering action of the device section W2 (Step 217), and transmits a withdrawn command that allows the holding of the wiring member H to be released and the hand section 101 to be moved from a connector connection position to a predetermined withdrawn position to the assembly robot 100 as the control signal (Step 205 in Fig. 6). The withdrawn position is not especially limited and is set at an appropriate position that does not inhibit assembling the device section W2 to the base section W1.

After the withdrawn of the hand section 101 of the assembly robot 100 to the predetermined withdrawn position is completed, a withdrawn completion notification is transmitted to the controller 3 (Step 106 in Fig. 6). When the controller 3 receives the withdrawn completion notification, the controller 3 transmits a release command of the coordination control to the transfer robot 200 (Step 303 in Fig. 6).

When the transfer robot 200 receives the release command of the coordination control from the controller 3, the transfer robot 200 switches from the second control mode to the first control mode and starts the assembly process of the device section W2 to the base section W1 (Step 206 in Fig. 6, Step 219 in Fig. 7) .

In the assembly process, after the transfer robot 200 horizontally moves the device section W2 to a position directly above the base section, the transfer robot 200 lowers and assembles the device section W2 to the base section W1 (see Fig. 5C). Thereafter, as shown in Fig. 6, the transfer robot 200 transmits an assembly completion notification to the controller 3 (Step S207), the controller 3 notifies the assembly robot 100 of an attachment start command of the shield plate S (Step 304) .

When the assembly robot 100 receives the attachment start command from the controller 3, the assembly robot 100 switches from the second control mode to the first control mode, arranges the shield plate S on an upper surface of the device section W2 set on the base section W1, and attaches the fixing screw (Step 107). Thereafter, the assembly robot 100 transmits the assembly completion notification to the controller 3 (Step 108) and the controller 3 notifies a transfer command to the transfer robot 200 (Step 305). After the transfer robot 200 receives the transfer command, the transfer robot 200 transfers the work W from the workbench 2 to a predetermined transfer line.

By execuding the above-described actions repeatedly, the work W is manufactured.

According to this embodiment, since an assembly operation of the work W is performed by the two robots 100 and 200, as compared with the case that the operation is performed by one robot, it is possible to improve operation efficiency, there is no need to ensure the temporal storage space of the device section to thereby reducing the operation space, and it can easily respond to a short wiring member.

According to this embodiment, since the wiring member H is connected to the connector C with the coordination control by the robots 100 and 200, it can ensure a stable connection operation while the disconnection or the damage of the wiring member H is avoided.

According to this embodiment, since the respective robots 100 and 200 are configured to be switchable between the independent control (first control mode) and the coordination control (second control mode), it becomes possible to assign other operations other than the connection operation of the wiring member H to the respective robots 100 and 200 and it is possible to promote an improvement of the operation efficiency.

### <Modification>

For example, the above embodiments are configured such that the start and the end of the coordination control by the assembly robot 100 and the transfer robot 200 (switching of first control mode and second control mode) are done on the basis of the notification from the controller 3, but it is not limited thereto, and the control modes may be switched by intercommunication between the assembly robot 100 and the transfer robot 200 not via the controller 3.

A timing of the start and the end of the coordination control between the assembly robot 100 and the transfer robot 200 is not limited to the above-described example. For example, the coordination control may be started by the start of the harness processing by the assembly robot 100 (Step 102), and the coordination control may be ended by the connector connection completion notification (Step 104).

The above embodiments describe that the coordination control by the plurality of robots is applied to the connection between the wiring member and the connector, but it is not limited thereto, and the coordination control by the plurality of robots may be applied to an operation of routing a long linear member such as an antenna cable. Alternatively, the present technology may be applied to a case that a large board for an FDP (Flat Panel Display) or a large structure is transferred by using a plurality of robots.

The present technology may also have the following structures.
(1) A robot apparatus, including:
   a first robot including a first hand section capable of holding one part of a work and a first control section capable of controlling the first hand section and generating a reference signal including information about at least a position of the first hand section; and
   a second robot including a second hand section capable of holding another part of the work and a second control section capable of selectively executing a first control mode that controls the second hand section and a second control mode that controls the second hand section by cooperating with the first hand section on the basis of the reference signal.
(2) The robot apparatus according to (1), in which
   the second control section generates a control signal that controls the first hand section in the second control mode, and
   the first control section controls the first hand section on the basis of the control signal.
(3) The robot apparatus according to (2), in which
   the second control section detects the position of the first hand section on the basis of the reference signal in the second control mode and individually controls the first hand section and the second hand section by using a common coordinate system to which the respective first hand section and second hand section belong.
(4) The robot apparatus according to (2) or (3), in which
   when the second control section detects that the first hand section arrives at a first predetermined position in the second control mode, the second control section allows the holding of the work by the first hand section to be released and generates a withdrawn command that allows the first hand section to be moved to a second predetermined position different from the first predetermined position as the control signal.
(5) The robot apparatus according to any one of (1) to (4), in which
   the second control section allows the second hand section and the first hand section to be synchronized and activated in the second control mode.
(6) The robot apparatus according to any one of (1) to (5), in which
   the second control section allows the second hand section and the first hand section to be moved in the same direction in the second control mode.
(7) The robot apparatus according to any one of (1) to (6), in which
   the second control section allows the second hand section and the first hand section to be moved at the same speed in the second control mode.
(8) The robot apparatus according to claim 1, further including:
   a controller that transmits a coordination control command signal allowing to execute the second control mode to the second control section.
(9) A method of manufacturing an electronic apparatus including a first work having a connection section and a second work having a linear or bandlike flexible member assembled to the first work and connected to the connection section, including:
   holding the flexible member of the second work held by the second robot with the first robot;
   allowing the second work and the flexible member to be moved toward the first work at the same time while the first robot and the second robot are coordinated and controlled; and
   after the flexible member is connected to the connection section, the second work is assembled to the first work.
(10) The method of manufacturing the electronic apparatus according to (9), in which
   the flexible member is a wiring member.

### Reference Signs List

- 1: robot apparatus
- 2: workbench
- 3: controller
- 100: assembly robot
- 101, 201: hand section
- 102, 202: articulated arm
- 103, 203: control section
- 104, 204: communication section
- 105, 205: force sensor
- 200: transfer robot
- C: connector
- H: wiring member
- W: work
- W1: base section
- W2: mechanism section

## Claims

1. A robot apparatus, comprising:
a first robot including a first hand section capable of holding one part of a work and a first control section capable of controlling the first hand section and generating a reference signal including information about at least a position of the first hand section; and
a second robot including a second hand section capable of holding another part of the work and a second control section capable of selectively executing a first control mode that controls the second hand section and a second control mode that controls the second hand section by cooperating with the first hand section on a basis of the reference signal.

2. The robot apparatus according to claim 1, wherein
the second control section generates a control signal that controls the first hand section in the second control mode, and
the first control section controls the first hand section on a basis of the control signal.

3. The robot apparatus according to claim 2, wherein
the second control section detects the position of the first hand section on a basis of the reference signal in the second control mode and individually controls the first hand section and the second hand section by using a common coordinate system to which the respective first hand section and second hand section belong.

4. The robot apparatus according to claim 2, wherein
when the second control section detects that the first hand section arrives at a first predetermined position in the second control mode, the second control section allows the holding of the work by the first hand section to be released and generates a withdrawn command that allows the first hand section to be moved to a second predetermined position different from the first predetermined position as the control signal.

5. The robot apparatus according to claim 1, wherein
the second control section allows the second hand section and the first hand section to be synchronized and activated in the second control mode.

6. The robot apparatus according to claim 1, wherein
the second control section allows the second hand section and the first hand section to be moved in the same direction in the second control mode.

7. The robot apparatus according to claim 1, wherein
the second control section allows the second hand section and the first hand section to be moved at the same speed in the second control mode.

8. The robot apparatus according to claim 1, further comprising:
a controller that transmits a coordination control command signal allowing to execute the second control mode to the second control section.

9. A method of manufacturing an electronic apparatus including a first work having a connection section and a second work having a linear or bandlike flexible member assembled to the first work and connected to the connection section, comprising:
holding the flexible member of the second work held by the second robot with the first robot;
allowing the second work and the flexible member to be moved toward the first work at the same time while the first robot and the second robot are coordinated and controlled; and
after the flexible member is connected to the connection section, the second work is assembled to the first work.

10. The method of manufacturing the electronic apparatus according to claim 9, wherein
the flexible member is a wiring member.
